# EUROPEAN PATENT APPLICATION

(11) **EP 3 627 282 A1**
(43) Date of publication of application: **25.03.2020**
(21) Application number: 18215457.5
(22) Date of filing: 21.12.2018
(51) Int. Cl.: G06F 1/20, H05K 7/20

(54) **THERMAL MANAGEMENT VIA OPERATING SYSTEM**

(30) Priority: 21.09.2018 US 201816138292
(71) Applicant: Quanta Computer Inc., Taoyuan City 33377 (TW)
(72) Inventor: Wang, Chun-Hung, Taoyuan City 33377 (TW)
(74) Representative: Krauns, Christian

(57) **Abstract**

Systems and methods are provided for thermally managing a computer component which is untethered to a management controller. An exemplary method can comprise obtaining monitoring information for one or more untethered, thermally sensitive components of the computing device. The monitoring information can comprise temperature. The method can then provide for transmitting, via an OS, the monitoring information to the management controller via a system interface of the management controller. The method finally provides for adjusting, via the management controller, operation of at least one thermal management component which is tethered to the management controller.

## Description

### FIELD

The present disclosure relates to temperature management in a computing system.

### BACKGROUND

Modern computing systems comprise numerous electronic components such as GPUs, CPUs, RAM, etc. As electronic components become faster and more powerful (e.g., with smaller form factors and faster GPUs or CPUs), more heat is generated within the electronic components. Without adequate cooling, overheating may occur, and cause physical damage to the components; and sometimes even lead to system failures and data loss.

In some computer systems, management controllers, such as a Baseboard Management Controller (BMC), monitor the temperature of the electronic components through direct electronic connections between the electronic components and the management controllers. For example, the management controller can be on a computer bus and can receive temperature information through inter-integrated circuit (I²C) connections between the computer bus and the electronic components. The computer system can then use cooling fans to remove excessive heat from the electronic components by actively exhausting accumulated hot air, thus maintaining suitable temperatures within the electronic components.

In some computer systems, the management controller is unable to communicate with the electronic components. For example, certain electronic components might not have I²C connections or any other direct electronic connections to the computer bus. Therefore, the management controller cannot detect temperatures of the electronic components and cannot accordingly adjust fan operation to maintain an acceptable temperature in the electronic components.

Therefore, there is a need for alternative systems and methods to provide temperature information to the management controller.

### SUMMARY

The various examples of the present disclosure are directed to a method of thermal management in a computing device using a management controller. The method comprises obtaining monitoring information for one or more thermally sensitive components of the computing device, where the components are untethered to the management controller. The monitoring information can comprise temperature information of the one or more thermally sensitive components. The method can then provide for transmitting, via the OS, the monitoring information to the management controller via a system interface of the management controller. The method finally provides for adjusting, via the management controller, operation of at least one thermal management component of the computing device tethered to the management controller.

A second embodiment of the present disclosure is directed towards a computer system for thermal management of a computing device using a management controller. The computer system can comprise one or more thermally sensitive components, a management controller, at least one thermal management component, and an operating system agent. The management controller can comprise a system interface and can be untethered to the one or more thermally sensitive components. The management controller can be configured to adjust operation of a thermal management component based on receiving monitoring information. The at least one thermal management component can be tethered to the management controller. The operating system can be comprised to obtain monitoring information of the one or more thermally sensitive components, and transmit the monitoring information to the management controller. The transmission can occur via the system interface of the management controller. The monitoring information can comprise temperature information of the one or more thermally sensitive components.

In a third embodiment of the present disclosure, a non-transitory computer readable medium can store instructions executable by at least one processor. The instructions can provide for obtaining monitoring information for one or more thermally sensitive components of the computing device, where the components are untethered to the management controller. The monitoring information can comprise temperature information of the one or more thermally sensitive components. The instructions can then provide for transmitting, via the OS, the monitoring information to the management controller via a system interface of the management controller. The instructions finally provide for adjusting, via the management controller, operation of at least one thermal management component of the computing device tethered to the management controller.

In some examples of the various embodiments, the monitoring information for each of the one or more thermally sensitive components can comprise a variety of information, including: identification information, a slowdown temperature, a shutdown temperature, and a current temperature.

In some examples of the various embodiments, at least one of the one or more thermally sensitive components can comprise a graphics processing unit.

In some examples of the various embodiments, the system interface can be a keyboard controller style interface.

In some examples of the various embodiments, the management controller can be a baseboard management controller.

The words "computer system," "computing system," and "server system" are all used interchangeably in the present disclosure, and can identify any electronic computing system for storing and processing data. Such an electronic computing system can include, but not be limited to, a personal computer, a laptop computer, a tablet, and a commercial or private server system.

### BRIEF DESCRIPTION OF THE DRAWINGS

The accompanying drawings exemplify the embodiments of the present invention and, together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements, and are not drawn to scale.
FIG. 1 is prior art that schematically depicts a conventional computer system with a GPU tethered to a management controller.
FIGs. 2A-2B are prior art that depicts how a conventional computer system responds to overheating of a tethered GPU.
FIG. 3 is prior art that schematically depicts a conventional computer system with an untethered GPU to a management controller.
FIGs. 4A-4C are prior art that depict how a conventional computer system responds to overheating of an untethered GPU.
FIG. 5 depicts an exemplary computer system, according to an embodiment of the present disclosure.
FIG. 6 depicts an exemplary OS operation structure, according to an embodiment of the present disclosure.
FIGs. 7A-7B depict how an exemplary computer system responds to overheating of an untethered GPU, according to an embodiment of the present disclosure.

### DETAILED DESCRIPTION

The present invention is described with reference to the attached figures, where like reference numerals are used throughout the figures to designate similar or equivalent elements. The figures are not drawn to scale and are provided merely to illustrate the instant invention. Several aspects of the invention are described below with reference to example applications for illustration. It should be understood that numerous specific details, relationships, and methods are set forth to provide a full understanding of the invention. One having ordinary skill in the relevant art, however, will readily recognize that the invention can be practiced without one or more of the specific details, or with other methods. In other instances, well-known structures or operations are not shown in detail to avoid obscuring the invention. The present invention is not limited by the illustrated ordering of acts or events, as some acts may occur in different orders and/or concurrently with other acts or events. Furthermore, not all illustrated acts or events are required to implement a methodology in accordance with the present invention.

The present disclosure is directed to the use of an operating system in a computer system to enable communication of temperature information to a management controller from a GPU untethered to the management controller. That is, enabling communication of temperature information when a GPU is not communicatively coupled to a management bus associated with the management controller. In this way, the management controller can still control fans in the computer system, according to the temperature information from the untethered GPUs. This allows for efficient GPU utilization, even in the absence of the connection through the management bus. In particular, the GPU temperature information can be obtained via an operating system (OS) agent. The OS can transmit the temperature information to a management controller via a systems interface of the management controller. The management controller can then control a fan speed rate according to temperature information of the untethered GPU. Therefore, the present disclosure provides a closed loop control system to automatically regulate fan speed rate to maintain an appropriate operating temperature of the untethered GPU without human interaction.

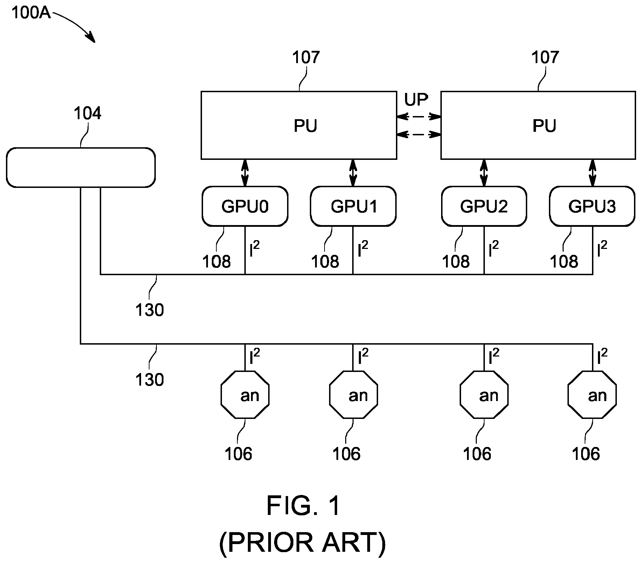

FIG. 1 schematically depicts a conventional computer system 100. Computer system 100 has central processing units (CPUs) 107. CPUs 107 are standard central processors that perform arithmetic and logical operations necessary for the operation of computer system 100. CPUs 107 can connect to graphic processor units (GPUs) 108. Like many electrical components, the CPUs 107 and the GPUs 108 produce heat while operating. As such, computer system 100 can include fans 106 to cool off the components in computer system 100. Fans 106 may be in close proximity with CPUs 107 and GPUs 108 to generate air flow and carry away heat generated by CPUs 107 and GPUs 108.

In system 100, a baseboard management controller (BMC) 104 determines when and how to operate fans 106 to cool off GPUs 108. GPUs 108 can communicate with BMC 104 via a management bus 130 of computer system 100. Management bus 130 is an I2C bus. During such communications, GPUs 108 can provide information regarding GPUs 108 health, operation, and performance conditions to BMC 104. Such information can include a GPU voltage and temperature. This information can be sent to BMC 104 by way of management bus 130. In response, the BMC 104 can determine how to operate fans 106 based on this information and other information available to BMC 104. For example, via management bus 130, the BMC 104 may have access to other sensors, such as tachometers, heat sensors, voltage meters, amp meters, and digital and analog sensors. Alternatively, some or all of these sensors may be incorporated into BMC 104 or other components of a computer system (not shown) connected to BMC 104. Thereafter, the BMC 104 can transmit control signals to fans 106 via management bus 130.

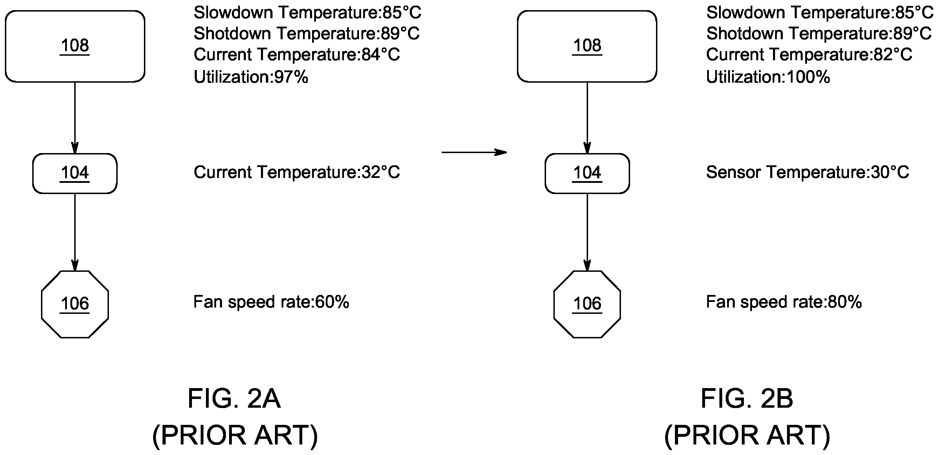

FIGs. 2A-2B provide a conventional, schematic representation of GPU 108, BMC 104, and fans 106 illustrating how BMC 104 uses both its internal temperature sensor and temperature readings from GPU 108 to control fans 106 in order to improve utilization at GPUs 108. In some instances, for the purposes of the present disclosure, either BMC 104 or GPU 108 may not have an internal temperature sensor. Temperature data for each component can be retrieved from a temperature sensor located proximally to the respective component. For example, BMC 104 temperature data can be determined based on a temperature sensor within the computer system which is closest to BMC 104.

Turning first to FIG. 2A, an initial condition is shown. BMC 104 detects an ambient temperature of 32 degrees Celsius; fan 106 merely operates at 60% capacity; the current temperature at GPU 108 is 84 degrees Celsius; and GPU 108 is operating at a 97% utilization. In this case, as GPU 108 has detected that it is near the predetermined slowdown threshold temperature of 85 degrees Celsius, GPU 108 has adjusted performance (i.e., capped utilization at 97%) in order to avoid overheating. GPU 108 can also be configured to have a predetermined shutdown threshold temperature, such as 89 degrees Celsius, that causes GPU 108 to automatically shutdown to prevent any damage to the components of GPU 108.

FIG. 2B shows subsequent conditions when GPU 108 is communicatively coupled to BMC 104 (as shown in FIG. 1). In computer system 100A, BMC 104 is able to control fan 106 to operate at a higher capacity to improve GPU utilization. That is, in response to the initial conditions in FIG. 2A, BMC 104 can be configured to consider temperatures at GPU 108 in determining a proper capacity for fans 106. In particular, FIG. 2B shows that fans 106 are reconfigured to operate at 80% capacity. This increase in fan 106 speed rate corresponds to a decrease in the temperature at GPU 108 to 82 degrees Celsius; and at BMC 104, to 30 degrees Celsius. Moreover, because of the reduced temperature, GPU 108 can increase its utilization. For example, as shown in FIG. 2B, utilization is increased to 100%.

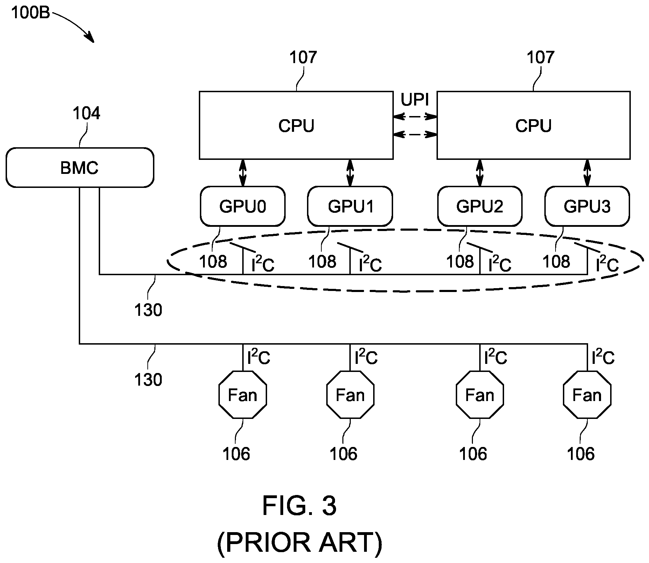

FIG. 3 schematically depicts a conventional computer system 100B where GPUs 108 are unable to communicate with BMC 104 by way of management bus 130. As shown in the circled region, GPUs 108 are no longer connected to BMC 104 via management bus 130 (i.e., GPUs 108 are untethered), and therefore, BMC 104 cannot receive temperature information of GPUs 108. For example, GPUs 108 in the computer system 100B might not support connections via an I2C bus. Consequently, BMC 104 cannot consider temperatures at GPUs 108 when controlling the capacity of fans 106. As a result, GPUs 108 may slow down or even shut down in order to prevent damage.

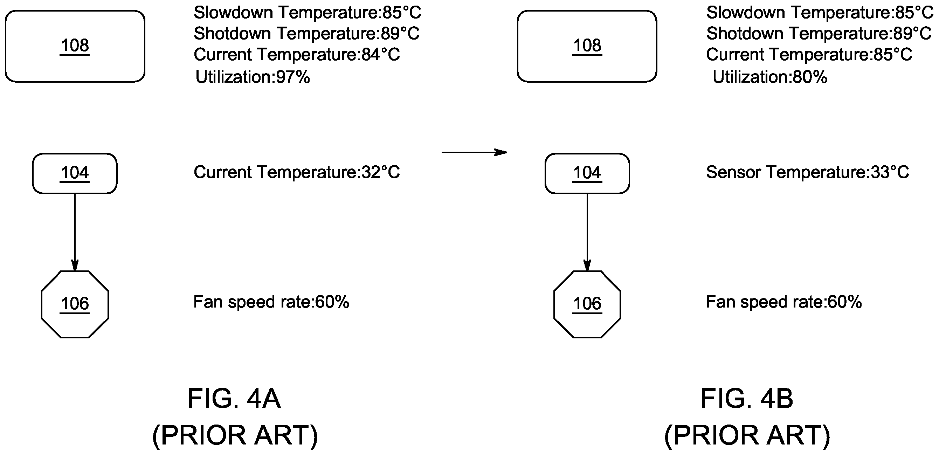

FIGs. 4A-4C provide a conventional, schematic representation of GPU 108, BMC 104, and fans 106. These illustrate how BMC 104 in computer system 100B would fail to consider temperature readings from GPUs 108 to control fans 106, thereby resulting in reduced utilization of GPUs 108.

Turning first to FIG. 4A, an initial condition is shown. BMC 104 detects an ambient temperature of 32 degrees Celsius; fan 106 merely operates at 60% capacity; the current temperature at GPU 108 is 84 degrees Celsius; and GPU 108 is operating at a 97% utilization. In this case, as GPU 108 has detected that it is near the predetermined slowdown threshold temperature of 85 degrees Celsius, GPU 108 adjusted performance (i.e., capped utilization at 97%) in order to avoid overheating. GPU 108 can also be configured to have a predetermined shutdown threshold temperature, such as 89 degrees Celsius, that causes GPU 108 to automatically shutdown to prevent any damage to the components of GPU 108.

FIGs. 4B-4C show subsequent conditions when GPU 108 is not communicatively coupled to BMC 104 (as shown in FIG. 1). In these cases, BMC 104 is unable to control fan 106 to operate at a higher capacity to improve GPU utilization. That is, in response to the initial conditions in FIG. 4A, BMC 104 does not receive temperature information from GPUs 108 and thus fails to consider temperatures at GPUs 108 in determining a proper capacity for fans 106. Rather, BMC 104 only considers the ambient temperature and fans 106 are maintained at 60% capacity. FIGs. 4B shows a resultant increase in temperature at BMC 104 to 33 degrees Celsius. This might be acceptable to BMC 104; however, this also results in an increase of temperature at GPUs 108 to 85 degrees Celsius. Therefore, because of the increased temperature at GPU 108, GPU 108 hits the slowdown threshold and decreases its utilization. For example, as shown in FIG. 4B, utilization is decreased to 80%.

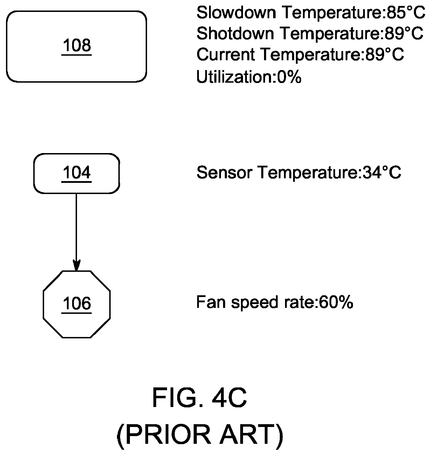

FIG. 4C shows further conditions subsequent to those shown in FIG. 4B. If the capacity of fans 106 is not sufficient to provide cooling at GPUs 108, the temperature at GPUs 108 will continue to increase. In some instances, this can result in the temperature at GPUs 108 reaching the shutdown threshold (89 degrees Celsius). At that point, utilization drops to 0% as the GPUs 108 shut down to prevent damage.

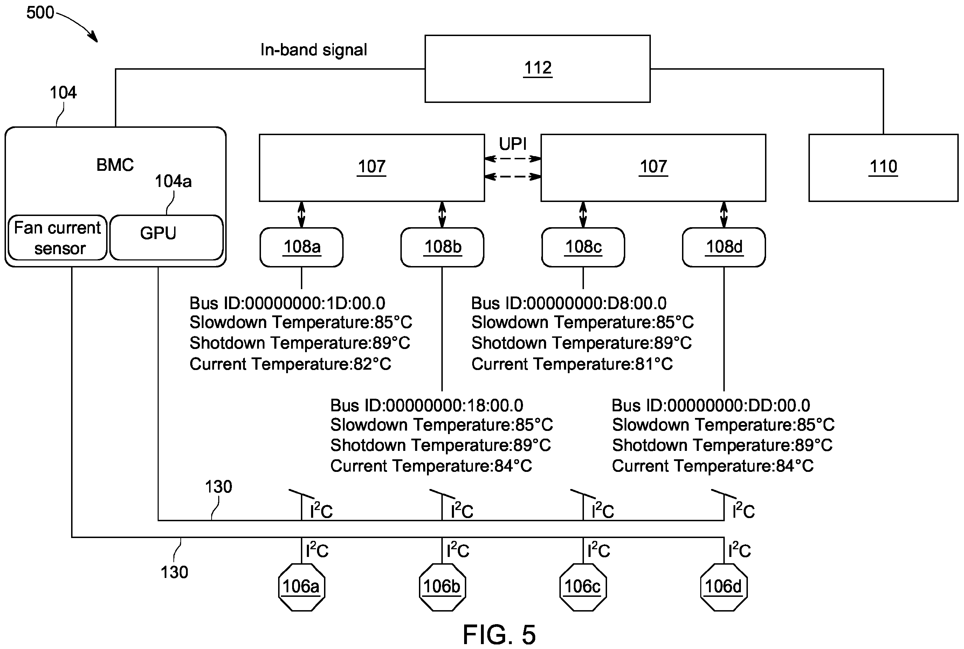

FIG. 5 depicts an exemplary computer system 500 configured to communicate between a BMC and an untethered GPU. Computer system 500 can include BMC 104, fans 106a, 106b, 106c, 106d (collectively "fans 106"), CPUs 107, GPUs 108a, 108b, 108c, 108d (collectively "GPUs 108"), and management bus 130. These components can operate similarly to identically labeled components in the computer systems of FIG. 3. In addition, computer system 500 can include OS 110 and system interface 112. OS 110 can be configured to obtain monitoring information from GPUs 108, and transmit the obtained information to BMC 104 via a system interface 112.

For example, OS 110 can collect from each GPU 108, monitoring information comprising a current temperature, a predetermined slowdown threshold temperature, and a predetermined shutdown threshold temperature. In some situations, current temperatures of each GPU 108 can differ. FIG. 5 shows GPU 108a has a current temperature of 82 degrees Celsius; GPU 108b has a temperature of 84 degrees Celsius, GPU 108c has a temperature of 81 degrees Celsius; and GPU 108d has a temperature of 84 degrees Celsius. The monitoring information can contain a bus ID of any of the GPUs. In some instances, the OS 110 can collect the current temperature from each GPU 108 from a temperature sensor on or inside GPU 108. In other instances, the OS 110 can collect the current temperature from a sensor located nearby GPU 108.

System interface 112 can be configured to put the obtained information from OS 110 into a raw data space 104a of BMC 104. Raw data space 104a can therefore hold information on a bus ID, current temperature, predetermined slowdown threshold temperature, and predetermined shutdown threshold temperature. BMC 104 can be configured to retrieve information stored in raw data space 104a to guide how to operate fans 106. For example, based on a high current temperature reading of GPUs 108, BMC 104 can notify fans 106 to increase operating speed. BMC 104 can notify individual fans 106a, 106b, 106c, or 106d to increase fan speed in response to individual overheating of corresponding GPUs 108a, 108b, 108c, or 108d.

Although GPUs 108 are referenced for some purposes of the present disclosure, the present disclosure is not limited in this regard. Rather, any untethered, thermally sensitive component of the computing device can be monitored by an OS 110 in substantially the same way as described herein.

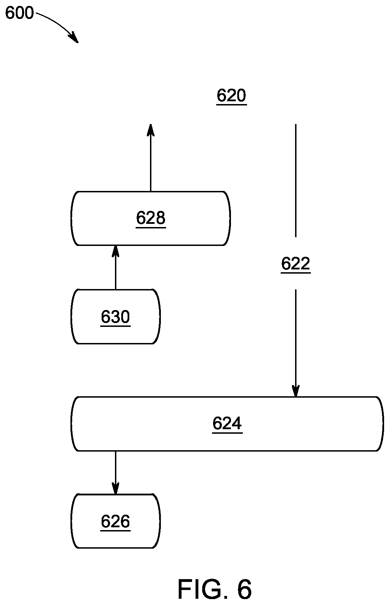

FIG. 6 depicts an exemplary operating structure 600, according to an embodiment of the present disclosure. Operating structure 600 can include an OS 620; system interface tool 622; a raw data space 624 at a management controller; a fan control protocol 626 of the management controller; a driver communication interface 628; and a device driver 630.

OS 620 can send a request for monitoring information from a GPU to a driver communication interface 628. Driver communication interface 628 can pass the request to device driver 630. In accordance with the present disclosure, device driver 630 is configured to retrieve the monitoring information from the GPU. After device driver 630 obtains the monitoring information, device driver 630 can pass the information to OS 620 through driver communication interface 628. OS 620 can then send the monitoring information via system interface tool 622. System interface tool 622 can be configured to save the monitoring information in raw data space 624 of a management controller. Subsequently, the management controller can access the monitoring information in raw data space 624. A fan control protocol 626 of the management controller can then operate based on the information. For example, fan control protocol 626 can read a slowdown temperature, shutdown temperature, and current temperature provided by each GPU. Fan control protocol 626 can then determine a level of cooling required by fans 106 for each GPU, and determine the appropriate fan speed rate signal for the management controller to send to the fans.

In certain implementations, device communication interface 628 can be a low-end API such as CUDA NVIDIA Management Library (NVML) and driver 630 can be a CUDA driver. NVML includes a series of commands for monitoring and managing various operational parameters, and operational data, which include current temperature, from computer components. The CUDA NVML API can load the runtime current temperature of a NVIDIA GPU from one of the parts of the library accessed by the CUDA driver. When the operating system is installed on the CUDA driver, the NVML may be called to the operating system. For example, because the operating system only boots up in the CPU, the NVIDIA GPU cannot execute any CPU instructions and must instead schedule the instructions in the CUDA driver. NVML can therefore provide a bridge between the CUDA driver and the GPU by using assembly code to access GPU information. However, the present disclosure is not limited to NVIDIA hardware or software components; a person skilled in the art understands that device communication interface 628 can be any method of interfacing with the GPU to retrieve GPU information.

The OS 620 can use IPMItool as the system interface tool 622 to send the in-band data to the raw data space 624 as raw data that can be used to change the fan speed rate. IPMItool is command prompt interface that can be used to enter command for managing Intelligent Platform Management Interface (IPMI) enabled devices.

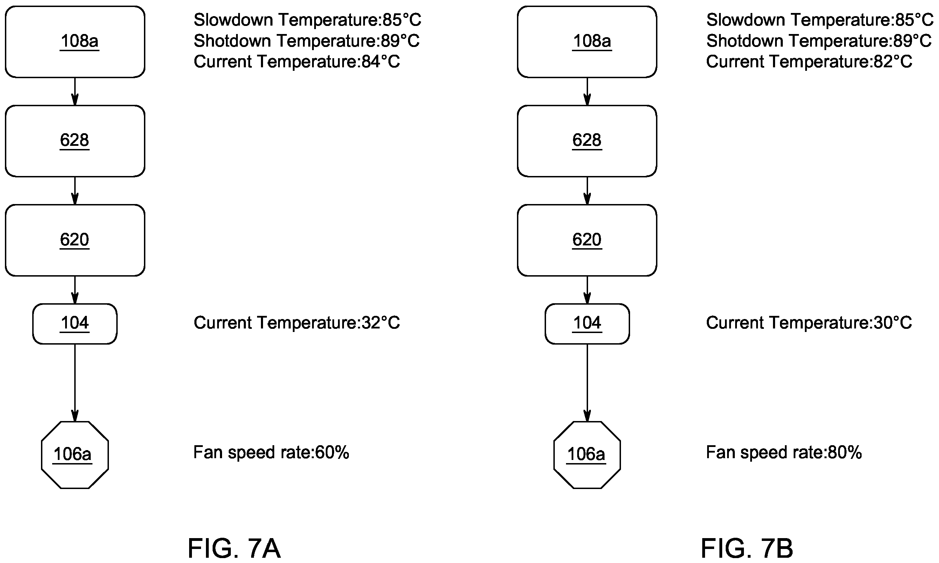

FIGs. 7A-7B provide a schematic representation of GPU 108a, BMC 104, and fan 106a. These illustrates how BMC 104 uses both its internal temperature sensor and temperature readings from GPU 108, provided via OS 620 and device communications interface 628, to control fan 106a to improve utilization at GPU 108a.

Turning first to FIG. 7A, an initial condition is shown. BMC 104 detects an ambient temperature of 32 degrees Celsius; fan 106a merely operates at 60% capacity; and a current temperature at GPU 108a is 84 degrees Celsius.

FIG. 7B shows subsequent conditions when temperature readings from GPU 108a, provided via OS 620 and device communications interface 628, are communicated to BMC 104 in accordance with the present disclosure. That is, in response to the initial conditions in FIG. 7A, BMC 104 can be configured to consider temperature information from GPU 108a in determining a proper capacity for fan 106a. In particular, FIG. 7B shows that fan 106a is reconfigured to operate at 80% capacity. This increase in capacity for fan 106a corresponds to a decrease in the temperature at GPU 108a to 82 degrees Celsius, and at BMC 104, to 30 degrees Celsius. Because of the reduced temperature at GPU 108a, GPU 108a can increase its utilization.

While various examples of the present invention have been described above, it should be understood that they have been presented by way of example only, and not limitation. Numerous changes to the disclosed examples can be made in accordance with the disclosure herein without departing from the spirit or scope of the invention. Thus, the breadth and scope of the present invention should not be limited by any of the above described examples. Rather, the scope of the invention should be defined in accordance with the following claims and their equivalents.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

The terminology used herein is for the purpose of describing particular examples only and is not intended to be limiting of the invention. As used herein, the singular forms "a," "an," and "the" are intended to include the plural forms as well, unless the context clearly indicates otherwise. Furthermore, to the extent that the terms "including," "includes," "having," "has," "with," or variants thereof, are used in either the detailed description and/or the claims, such terms are intended to be inclusive in a manner similar to the term "comprising."

Unless otherwise defined, all terms (including technical and scientific terms) used herein have the same meaning as commonly understood by one of ordinary skill in the art to which this invention belongs. Furthermore, terms, such as those defined in commonly used dictionaries, should be interpreted as having a meaning that is consistent with their meaning in the context of the relevant art and will not be interpreted in an idealized or overly formal sense unless expressly so defined herein.

## Claims

1. A method of thermal management in a computing device using a management controller, comprising:
obtaining, via an operating system (OS) agent, monitoring information of one or more thermally sensitive components of the computing device untethered to the management controller (104), the monitoring information comprising temperature information of the one or more thermally sensitive components;
transmitting, via the OS (620), the monitoring information to the management controller (104) via a system interface (112) of the management controller (104); and
adjusting, via the management controller (104), operation of at least one thermal management component of the computing device tethered to the management controller (104).

2. The method of claim 1, wherein the monitoring information for each of the one or more thermally sensitive components comprises identification information.

3. The method of claim 1 or 2, wherein the monitoring information for each of the one or more thermally sensitive components comprises a slowdown temperature, a shutdown temperature, and a current temperature.

4. The method of anyone of the claims 1 to 3, wherein at least one of the one or more thermally sensitive components comprises a graphics processing unit.

5. The method of anyone of the claim 1 to 4, wherein the system interface is a keyboards controller style interface.

6. A computer system (500) for thermal management of a computing device using a management controller, wherein the computer system (500) comprises:
one or more thermally sensitive components;
a management controller (104), comprising a system interface (112), wherein the management controller (104) is untethered to the one or more thermally sensitive components, wherein the management controller (104) is configured to adjust operation of a thermal management component based on receiving monitoring information;
at least one thermal management component tethered to the management controller (104);
an operating system (OS) agent, configured to:
obtain monitoring information of the one or more thermally sensitive components, the monitoring information comprising temperature information of the one or more thermally sensitive components; and
transmit the monitoring information to the management controller (104) via the system interface (112) of the management controller (104).

7. The computer system of claim 6, wherein the monitoring information for each of the one or more thermally sensitive components comprises identification information.

8. The computer system of claim 6 or 7, wherein the monitoring information for each of the one or more thermally sensitive components comprises a slowdown temperature, a shutdown temperature, and a current temperature.

9. The computer system of anyone of the claims 6 to 8, wherein at least one of the one or more thermally sensitive components comprises a graphics processing unit.

10. The computer system of anyone of the claims 6 to 9, wherein the system interface is a keyboards controller style interface.

11. A non-transitory computer readable medium that stores instructions executable by at least one processor, the instructions comprising:
obtaining, via an operating system (OS) agent, monitoring information of one or more thermally sensitive components of the computing device untethered to the management controller (104), the monitoring information comprising temperature information of the one or more thermally sensitive components;
transmitting, via the OS (620), the monitoring information to the management controller (104) via a system interface (112) of the management controller (104); and
adjusting, via the management controller (104), operation of at least one thermal management component of the computing device tethered to the management controller (104).

12. The non-transitory computer readable medium of claim 11, wherein the monitoring information for each of the one or more thermally sensitive components comprises identification information.

13. The non-transitory computer readable medium of claim 11 or 12, wherein the monitoring information for each of the one or more thermally sensitive components comprises a slowdown temperature, a shutdown temperature, and a current temperature.

14. The non-transitory computer readable medium of anyone of the claims 11 to 13, wherein at least one of the one or more thermally sensitive components comprises a graphics processing unit.

15. The non-transitory computer readable medium of anyone of the claims 11 to 14, wherein the system interface is a keyboards controller style interface.

## Amended claims

### Amended claims in accordance with Rule 137(2) EPC.

1. A method of thermal management in a computing device using a management controller (104), comprising:
obtaining, via an operating system, OS, agent, monitoring information of a thermally sensitive component of the computing device not having any direct electronic connections to the management controller (104), the monitoring information comprising temperature information of the thermally sensitive component;
transmitting, by the OS (620), the monitoring information to the management controller (104) via a system interface (112) of the management controller (104); and
adjusting, via the management controller (104), operation of at least one thermal management component of the computing device having direct electronic connections to the management controller (104) by using the monitoring information.

2. The method of claim 1, wherein the monitoring information for the thermally sensitive component comprises identification information.

3. The method of claim 1 or 2, wherein the monitoring information for the thermally sensitive component comprises a slowdown temperature, a shutdown temperature, and a current temperature.

4. The method of anyone of the claims 1 to 3, wherein the thermally sensitive component comprises a graphics processing unit (108a, 108b, 108c, 108d).

5. The method of anyone of the claim 1 to 4, wherein the system interface (112) is a keyboards controller style interface.

6. A computer system (500) for thermal management of a computing device using a management controller (104), wherein the computer system (500) comprises:
a thermally sensitive component;
a management controller (104), comprising a system interface (112), wherein the management controller (104) is not having any direct electronic connections to the thermally sensitive component, wherein the management controller (104) is configured to adjust operation of a thermal management component based on receiving monitoring information;
at least one thermal management component having direct electronic connections to the management controller (104) by using the monitoring information;
an operating system, OS, agent, configured to:
obtain monitoring information of the thermally sensitive component, the monitoring information comprising temperature information of the thermally sensitive component; and
transmit the monitoring information to the management controller (104) via the system interface (112) of the management controller (104).

7. The computer system (500) of claim 6, wherein the monitoring information for the thermally sensitive component comprises identification information.

8. The computer system (500) of claim 6 or 7, wherein the monitoring information for the thermally sensitive component comprises a slowdown temperature, a shutdown temperature, and a current temperature.

9. The computer system (500) of anyone of the claims 6 to 8, wherein the thermally sensitive component comprises a graphics processing unit (108a, 108b, 108c, 108d).

10. The computer system (500) of anyone of the claims 6 to 9, wherein the system interface (112) is a keyboards controller style interface.

11. A non-transitory computer readable medium that stores instructions executable by at least one processor, the instructions comprising:
obtaining, via an operating system, OS, agent, monitoring information of thermally sensitive component of the computing device not having any direct electronic connections to the management controller (104), the monitoring information comprising temperature information of the thermally sensitive component;
transmitting, by the OS (620), the monitoring information to the management controller (104) via a system interface (112) of the management controller (104); and
adjusting, via the management controller (104), operation of at least one thermal management component of the computing device having direct electronic connections to the management controller (104) by using the monitoring information.

12. The non-transitory computer readable medium of claim 11, wherein the monitoring information for the thermally sensitive component comprises identification information.

13. The non-transitory computer readable medium of claim 11 or 12, wherein the monitoring information for the thermally sensitive component comprises a slowdown temperature, a shutdown temperature, and a current temperature.

14. The non-transitory computer readable medium of anyone of the claims 11 to 13, wherein the thermally sensitive component comprises a graphics processing unit (108a, 108b, 108c, 108d).

15. The non-transitory computer readable medium of anyone of the claims 11 to 14, wherein the system interface (112) is a keyboards controller style interface.
